# EUROPÄISCHE PATENTSCHRIFT

(11) **EP 3 257 117 B1**
(45) Veröffentlichungstag und Bekanntmachung des Hinweises auf die Patenterteilung: **01.04.2020**
(21) Anmeldenummer: 16703531.0
(22) Anmeldetag: 05.02.2016
(51) Int. Cl.: H01R 43/055

(54) **CRIMPMASCHINE**
CRIMPING MACHINE
MACHINE DE SERTISSAGE

(30) Priorität: 12.02.2015 DE 102015102060
(43) Veröffentlichungstag der Anmeldung: 20.12.2017
(73) Patentinhaber: Zoller & Fröhlich GmbH, 88239 Wangen im Allgäu (DE)
(72) Erfinder: FRÖHLICH, Christoph, 88239 Wangen (DE); HARTINGER, Steffen, 88239 Wangen (DE); LEUPOLZ, Hans, 88260 Argenbühl (DE)
(74) Vertreter: Winter, Brandl, Fürniss, Hübner, Röss, Kaiser, Polte - Partnerschaft mbB
(86) Internationale Anmeldenummer: PCT/EP2016/052567
(87) Internationale Veröffentlichungsnummer: WO 2016/128331

(56) Entgegenhaltungen:
- EP-A1- 0 889 560
- EP-A1- 1 667 289
- WO-A1-2014/181729
- JP-A- 2005 135 822

## Beschreibung

Die Erfindung betrifft eine Crimpmaschine gemäß dem Oberbegriff des Patentanspruchs 1.

Eine derartige Crimpmaschine ist beispielsweise aus der Patentschrift DE 44 40 835 C1 der Anmelderin bekannt und dient beispielsweise dazu, Aderendhülsen mit einem abisolierten Kabelende zu verpressen. Diese Aderendhülsen werden bei der bekannten Lösung als Gurtband auf einem Trommelmagazin aufgerollt und von diesem über eine Transporteinheit zu einem Crimpkopf gefördert. Alternativ können die Aderendhülsen bzw. Kontaktelemente auch vereinzelt in einem Speicher aufgenommen sein und dann über eine geeignete Zuführeinrichtung lagedefiniert zum Crimpkopf gefördert werden. Eine derartige Zuführeinrichtung ist beispielsweise in der DE 198 31 588 A1 beschrieben.

Die zu vercrimpende Aderendhülse wird bei den bekannten Lösungen mittels einer Halteeinheit auf das abisolierte Kabelende aufgesetzt und dann über den Crimpkopf verpresst. Das Abisolieren des Kabelendes kann entweder extern oder über einen in die Crimpmaschine integrierten Abisolierkopf erfolgen.

Der Aufbau einer Transporteinheit zum Fördern der auf einem Gurtband angeordneten Aderendhülsen oder sonstiger elektrischer Bauteile ist beispielsweise in der Druckschrift G 93 08 266.5 der Anmelderin beschrieben. Eine ähnliche Transporteinheit ist auch in der DE 197 14 964 C1 offenbart. EP 0889560 offenbart eine Crimpmaschine nach dem Oberbegriff des unabhängigen Anspruchs 1.

In der Serienproduktion ist es erforderlich, unterschiedliche Kabelquerschnitte und elektrische Bauelemente/Kontaktelemente miteinander zu verpressen und dann in einem folgenden Montagschritt, beispielsweise beim Montieren eines Schaltschranks zu verbauen. Hierzu verbleiben prinzipiell zwei Möglichkeiten: Bei einer Variante wird die Crimpmaschine zum Verpressen unterschiedlicher Kabelquerschnitte und/oder Kontaktelemente (Aderendhülsen) umgerüstet oder aber es werden mehrere Crimpmaschinen zur Verarbeitung der unterschiedlichen Kabelquerschnitte/Kontaktelemente vorgesehen. Die erstgenannte Lösung bedarf hoher Rüstzeiten und eines erheblichen Personalaufwandes. Dieser Nachteil wird bei der letztgenannten Lösung mit einer Vielzahl von Crimpmaschinen überwunden - die Investitionskosten sind jedoch erheblich.

Dem gegenüber liegt der Erfindung die Aufgabe zugrunde, eine Crimpmaschine zu schaffen, die bei vergleichsweise einfachem Aufbau eine flexible Fertigung ermöglicht.

Diese Aufgabe wird durch eine Crimpmaschine mit den Merkmalen des Patentanspruchs 1 gelöst.

Vorteilhafte Weiterbildungen der Erfindung sind Gegenstand der Unteransprüche.

Die Crimpmaschine ist zum Verpressen von Kontaktelementen mit einem Endabschnitt eines Leiters, beispielsweise eines Kabelendes vorgesehen und hat eine Speichereinrichtung für die Kontaktelemente und eine Transporteinrichtung zum Zuführen der Kontaktelemente vom Speicher hin zu einem Crimpkopf. Erfindungsgemäß hat die Speicheranordnung zumindest zwei, vorzugsweise fünf Speicher mit unterschiedlichen Kontaktelementen, wobei diesen Speichern eine gemeinsame Transporteinrichtung zum Transport des Kontaktelementes von einer Übergabeposition zum Crimpkopf zugeordnet ist.

Über eine geeignete Ansteuerung der Transporteinrichtung kann dann dem Crimpkopf ein für den jeweiligen Fertigungsschritt vorgesehenes Kontaktelement zugeführt werden, das dann mit dem über eine Zentriereinrichtung mit Bezug zum Crimpkopf ausgerichtetem Leiter vercrimpt wird.

Eine derartige Crimpmaschine ermöglicht eine äußerst flexible Verarbeitung der Bauelemente ohne dass es erheblicher Investitionskosten oder Rüstzeiten bedarf.

Bei einem Ausführungsbeispiel der Erfindung erfolgt der Transport der Kontaktelemente von jedem Speicher zu der Übergabeposition über eine geeignete Fördereinheit, deren prinzipieller Aufbau beispielsweise aus dem vorbeschriebenen Stand der Technik bekannt ist. Bei einer derartigen Variante ist eine der Anzahl an Speichern entsprechende Anzahl von Fördereinheiten zum Transport der Aderendhülsen in die Übergabeposition vorgesehen.

Erfindungsgemäß hat die Transporteinheit ein Shuttle zur Übernahme des sich in der Übergabeposition befindlichen Kontaktelementes und zu dessen Transport hin zu einer Crimpposition.

Das Shuttle hat zumindest einen Greifer, der am Kontaktelement vorzugsweise quer zur Kontaktelementlängsachse angreift. Durch diesen Greifer kann dann das sich in der Übergabeposition befindliche Kontaktelement ergriffen und zum Crimpkopf gefördert werden.

Zur Verkürzung der Produktionszeit ist das Shuttle erfindungsgemäß mit zwei parallel angeordneten Greifern ausgeführt, wobei ein Greifer das sich in der Übergabeposition befindliche Kontaktelement übernimmt und der zweite Greifer ein in einem folgenden Arbeitsgang zu verpressendes Kontaktelement greift. Auf diese Weise ist es beispielsweise möglich, beide Endabschnitte eines Kabelendes mit minimalem Fertigungsaufwand mit entsprechenden Kontaktelementen zu verpressen, wobei diese Kontaktelemente unterschiedlich sein können.

Bei einer Variante des Shuttles sind die Greifer entlang einer Führung verfahrbar, so dass die Greifer in einer Ebene von der Übergabeposition in die Crimpposition verfahrbar sind. Dabei handelt es sich vorzugsweise um eine Vertikalebene mit Bezug zur Standfläche der Crimpmaschine.

Der Aufbau der Crimpmaschine ist besonders einfach, wenn die Kontaktelemente jeweils als Gurtband auf einem Trommelmagazin angeordnet sind. Derartige Trommelmagazine lassen sich sehr einfach wechseln, so dass die Rüstzeiten weiter verringert sind. Des Weiteren vereinfacht die durch das Gurtband vorgegebene Lageorientierung die folgende Verarbeitung der Kontaktelemente.

Selbstverständlich können alternativ auch Einzelteile vercrimpt werden, wobei allerdings der Aufwand zur lagegerechten Positionierung der einzelnen Kontaktelemente berücksichtigt werden muss.

In dem Fall, in dem die Kontaktelemente als Gurtband bereitgestellt sind, kann eine Schneideinrichtung zum Abtrennen des sich in der Übergabeposition befindlichen Kontaktelementes vom Gurtband vorgesehen sein.

Eine derartige Schneideinrichtung hat bei einem Ausführungsbeispiel eine der Anzahl von Speichern entsprechende Anzahl von Schneidmessern, wobei allerdings lediglich das Schneidmesser in Wirkeingriff gelangt, das dem sich in der Übergabeposition befindlichen Kontaktelement zugeordnet ist.

Die Zentriereinrichtung zum Zentrieren des Leiters mit Bezug zur Crimpposition hat bei einem Ausführungsbeispiel eine Vielzahl von Zentrieröffnungen. Durch Verfahren dieser Zentrierführung kann diejenige Zentrieröffnung, die dem zu verarbeitenden Leiterquerschnitt zugeordnet ist, mit Bezug zur Crimpposition ausgerichtet werden.

Bei einem Ausführungsbeispiel hat die Zentriereinrichtung zwei Zentrierbacken, die zum Entnehmen des verpressten Produkts auffahrbar sind.

Ein sehr kompakter Aufbau der Crimpmaschine ist realisierbar, wenn die jeweiligen Übergabepositionen der Transporteinheiten übereinanderliegend angeordnet sind, so dass der Greifer zwischen den Transportebenen verfahrbar ist und die Trenneinrichtung quer dazu, d. h., parallel zur Achse des Crimpkopfes und/oder der Zentriereinrichtung verfahrbar ist.

Die Betriebssicherheit der Crimpmaschine lässt sich verbessern, wenn diese mit einer Abdeckung versehen ist und eine Sicherheitsschaltung aufweist, die bei einem ungewollten Öffnen der Abdeckung die Energieversorgung unterbricht. Um ein Rüsten der Crimpmaschine zu erleichtern, ist diese mit einer Rüstschaltung ausgeführt, die die Funktion der Crimpmaschine bei geöffneter Schutzhaube ermöglicht.

Der Automatisierungsgrad lässt sich erhöhen, wenn das Zuführen der Kontaktelemente über eine geeignete Zuführeinheit, beispielsweise ein Handlingsgerät oder dergleichen erfolgt.

Durch geeignete Auslegung einer Steuereinheit der Crimpmaschine kann das Ansteuern der Transporteinheit derart erfolgen, dass diese ein bestimmtes, sich in einer Übergabeposition befindliches Kontaktelement übernimmt und zur Crimpposition verbringt.

Das Programmieren der Crimpmaschine erfolgt vorzugsweise über ein Bedienfeld. Dieses Bedienfeld kann zur Verbesserung des Bedienkomforts abnehmbar an einem Gehäuse der Crimpmaschine gehalten sein.

Ein bevorzugtes Ausführungsbeispiel der Erfindung wird im Folgenden anhand schematischer Zeichnungen näher erläutert. Es zeigen:
Figur 1 eine dreidimensionale Vorderansicht einer erfindungsgemäßen Crimpmaschine;
Figur 2 eine Seitenansicht der Crimpmaschine gemäß Figur 1;
Figur 3 die Crimpmaschine in der Ansicht nach Figur 1 mit abgenommenen Gehäuseelementen;
Figur 4 die Crimpmaschine in einer Rückansicht mit abgenommenen Gehäuseelementen;
Figur 5 eine vergrößerte Detaildarstellung der Ansicht gemäß Figur 3;
Figur 6 eine Einzelansicht einer Fördereinheit der Crimpmaschine gemäß den Figuren 1 bis 5;
Figur 7 eine Einzeldarstellung einer Schneideinrichtung der Crimpmaschine;
Figur 8 eine Rückansicht der Schneideinrichtung gemäß Figur 7;
Figur 9 ein Shuttle der Crimpmaschine;
Figur 10 eine Detaildarstellung des Shuttles gemäß Figur 9;
Figur 11 eine Einzeldarstellung des Crimpkopfs der Crimpmaschine und
Figur 12 eine Seitenansicht des Crimpkopfs gemäß Figur 11.

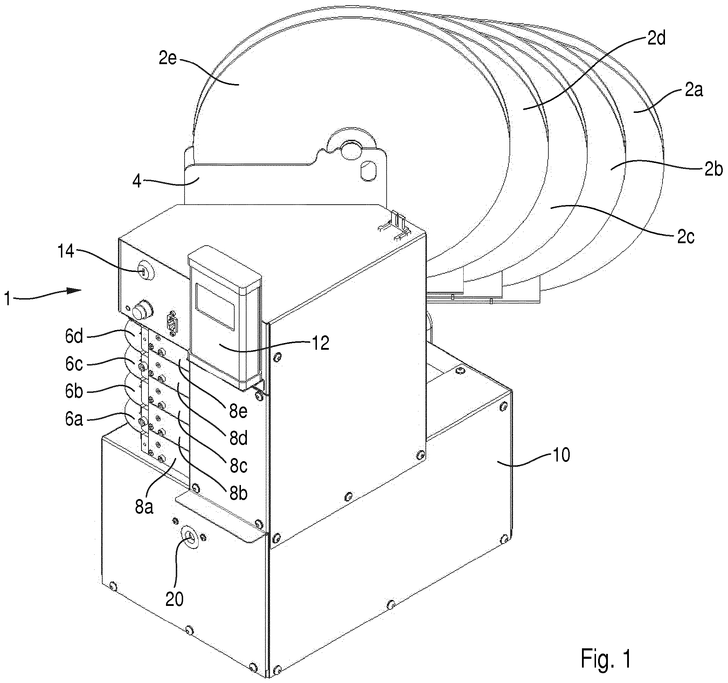

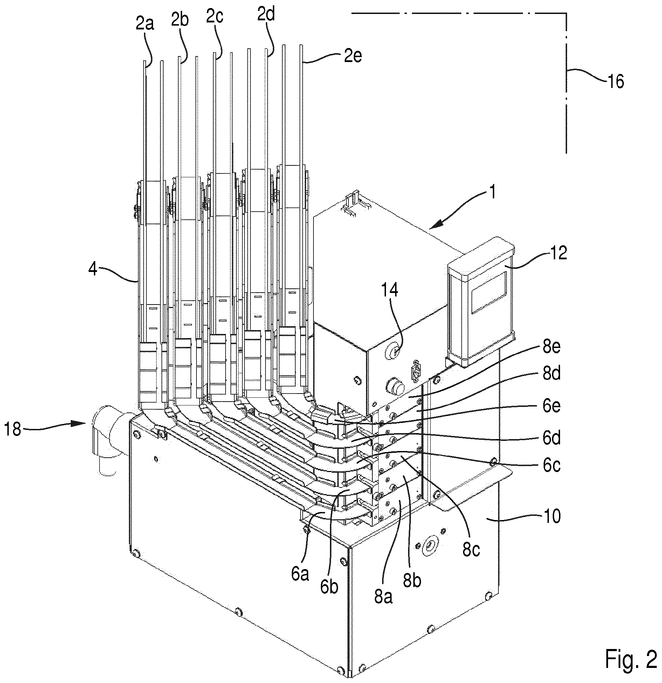

Figur 1 zeigt eine dreidimensionale Vorderansicht einer Crimpmaschine 1, mit der fünf unterschiedliche Aderendhülsen oder sonstige Kontaktelemente verarbeitbar sind. Bei dem im Folgenden beschriebenen Ausführungsbeispiel ist die Crimpmaschine 1 zur Verarbeitung von Aderendhülsen für unterschiedliche Kabelquerschnitte beschrieben. Die Aderendhülsen sind als Gurtband bereitgestellt. Diese Gurtbänder sind auf insgesamt fünf Trommelmagazine 2a, 2b, 2c, 2d und 2 e aufgewickelt und an einem Magazinhalter 4 der Crimpmaschine drehbar gelagert. Gemäß der Darstellung in Figur 2, die die Crimpmaschine 1 in einer Ansicht von links in Figur 1 zeigt, sind in Verlängerung der in der Ansicht nach Figur 2 unten liegenden Umfangsabschnitte der Trommelmagazine 2a bis 2e Führungsbahnen 6a, 6b, 6c, 6d und 6e ausgebildet, deren Endabschnitte in jeweils eine Fördereinheit 8a, 8b, 8c, 8d bzw. 8e einmünden. Über diese wird das nicht dargestellte Gurtband von den Trommelmagazinen 2 abgerollt und je nach Ansteuerung der Crimpmaschine 1 die Aderendhülse eines vorbestimmten Gurtbandes in eine im Folgenden noch näher erläuterte Übergangsposition transportiert. Wie aus der Darstellung gemäß Figur 2 erkennbar, sind die Transporteinheiten 8a, 8b, 8c, 8d, 8e in Vertikalrichtung übereinanderliegend angeordnet, so dass entsprechend auch die zugeordneten Führungsbahnen 6a, 6b, 6c, 6d, 6e in diesen übereinanderliegenden Ebenen münden. Der Magazinhalter 4, die genannten Führungsbahnen 6 und die Fördereinheiten 8 sind an einem Rahmen der Crimpmaschine 1 gehalten.

Die sonstigen Funktionselemente der Crimpmaschine 1 sind von einem mehrteiligen Gehäuse 10 umschlossen. Die Programmierung und Eingabe der Produktionsparameter für die ebenfalls im Gehäuse 10 aufgenommene Steuereinheit erfolgt über ein Bedienfeld 12, das entweder ins Gehäuse 10 integriert ist oder-wie im vorliegenden Fall - abnehmbar am Gehäuse 10 gehalten wird. Sichtbar in der Darstellung gemäß den Figuren 1 und 2 ist des Weiteren ein Schloss 14 zum Ein- und Ausschalten der Crimpmaschine 1 und zum Einstellen eines Rüstmodus, der die Betätigung der Crimpmaschine 1 auch dann ermöglicht, wenn eine für die Betriebssicherheit erforderliche, strichpunktiert angedeutete Abdeckung 16 geöffnet wird. Im normalen Betrieb wird bei Öffnen der Abdeckung 16 die Energie- und Betriebsmittelversorgung der Crimpmaschine 1 aus Sicherheitsgründen unterbrochen. Zum Einstellen/Umrüsten kann dann der vorbeschriebene Rüstmodus eingestellt werden, der einen Betrieb der Crimpmaschine 1 auch bei offener Abdeckung ermöglicht. Diese Umstellung ist jedoch nur für einen gewissen Personenkreis einstellbar.

Wie in Figur 2 angedeutet, sind an der vom Bedienfeld 12 abgewandten Rückseite der Crimpmaschine 1 Energie- und Betriebsmittel-Versorgungsanschlüsse 18 ausgebildet. Die im Folgenden beschriebenen Komponenten der Crimpmaschine 1 sind entweder elektromotorisch oder pneumatisch angetrieben, so dass entsprechend die Stromversorgung und die Druckluftversorgung rückseitig an der Crimpmaschine 1 angeschlossen ist.

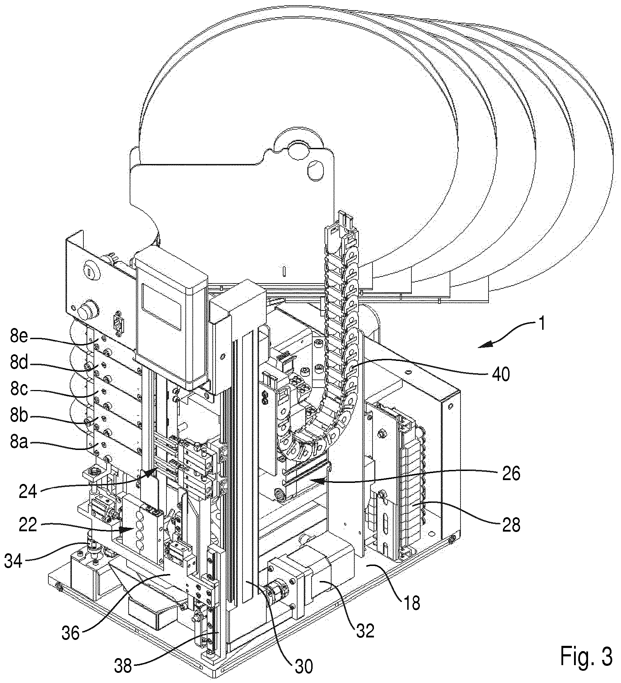

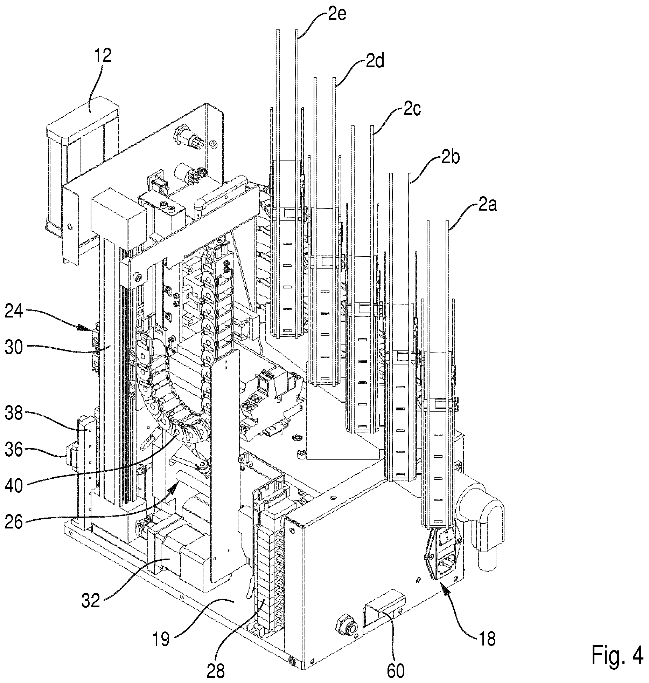

In den dreidimensionalen Darstellungen gemäß den Figuren 3 und 4 sind Teile des Gehäuses 10 abgenommen, so dass einige im Folgenden noch näher erläuterte Funktionselemente der Crimpmaschine 1 sichtbar sind. Diese Funktionselemente sind unmittelbar oder mittelbar auf einer Grundplatte 19 des Gehäuses 10 montiert. In Figur 4 sichtbar sind die vorbeschriebenen Anschlüsse 18 für Strom, Druckluft sowie für Ein- und Ausgangssignale zum Betrieb in einer Fertigungslinie, in die die Crimpmaschine 1 integriert ist.

An der in Figur 1 sichtbaren Vorderseite des Gehäuses 10 ist eine Einführöffnung 20 für das Kabelende vorgesehen, das mit der sich in der Übergabeposition befindlichen Aderendhülse vercrimpt werden soll.

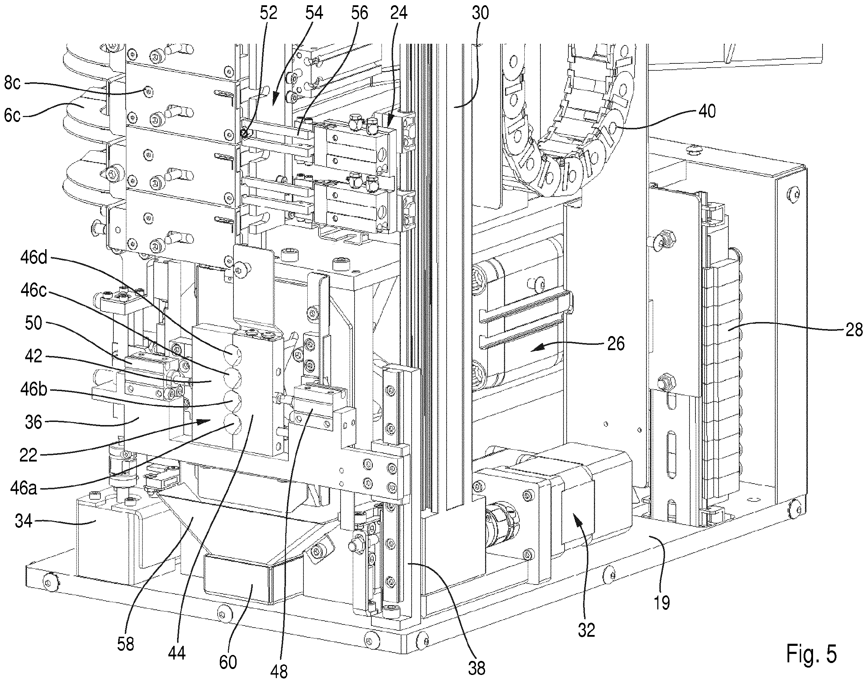

Bei abgenommener Gehäuseüberdeckung wird die hinter der Einführöffnung 20 angeordnete Zentriereinrichtung 22 sichtbar, die, wie später noch anhand Figur 5 erläutert wird, in Vertikalrichtung (Ansicht nach Figur 3) verfahrbar ist, so dass sie mit Bezug zu einer Crimpposition lagepositioniert werden kann. Diese Zentriereinrichtung 22 dient zur Zentrierung des zugeführten Kabelendes mit Bezug zu dieser Crimpposition.

Wie vorstehend erläutert, wird über die Fördereinheiten 8a bis 8e durch entsprechende Ansteuerung der nicht dargestellten Steuereinheit eine bestimmte Aderendhülse in eine Übergabeposition gebracht und dann mittels eines im Folgenden noch näher erläuterten Schneidmessers vom Gurtband abgetrennt. Dabei wird die betreffende Aderendhülse von einem Shuttle 24 gehalten und dann in Vertikalrichtung in die Crimpposition verfahren. Wie erläutert, ist die Zentriereinrichtung 22 mit Bezug zu dieser Crimpposition ausgerichtet, so dass das abisolierte Kabelende in die vom Shuttle 24 oder einem sonstigen Greifer gehaltene Aderendhülse eingeführt werden kann. In einem folgenden Arbeitsgang wird dann ein Crimpkopf 26 angesteuert, um die Aderendhülse und das Kabelende miteinander zu vercrimpen. Wie eingangs erläutert, erfolgt das Zuführen des abisolierten Kabelendes bei einer Fertigungslinie über ein geeignetes Handlingsgerät. Das Abisolieren kann dabei in einem vorgeschalteten Verfahrensschritt erfolgen. Prinzipiell kann jedoch auch ein Abisolierkopf in die Crimpmaschine integriert sein. Ein derartiger Abisolierkopf ist beispielsweise in der eingangs beschriebenen DE 44 40 835 C1 erläutert.

In den Ansichten gemäß den Figuren 3 und 4 sichtbar sind noch Anschlussklemmen 28 für die Stromversorgung der elektrisch betriebenen Komponenten. Das Shuttle 24 ist gemäß den Figuren 3 und 4 an einer Führungssäule 30 gelagert und mittels eines elektromotorischen Shuttleantriebs 32 in Vertikalrichtung verfahrbar, um die jeweilige, in ihre Übergabeposition verbrachte Aderendhülse übernehmen zu können.

Die Höhenverstellung der Zentriereinrichtung 22 erfolgt ebenfalls elektromotorisch über einen Zentrierantrieb 34, wobei die eigentliche Zentriereinrichtung 22 auf einer Konsole 36 gelagert ist. Diese ist entlang einer Vertikalführung 38 verfahrbar. D. h., sowohl das Shuttle 24 als auch die Zentriereinrichtung 22 sind in Vertikalrichtung parallel zueinander verfahrbar. Die Druckluftversorgung des Shuttles 24 erfolgt dabei über in einer Gliederkette 40 geführte Druckluftschläuche, deren Endabschnitt mit dem Shuttle 24 mitfährt.

Figur 5 zeigt eine Detaildarstellung der Crimpmaschine 1 in einer Figur 3 entsprechenden Ansicht, aus der der Grundaufbau der Zentriereinrichtung 22 hervorgeht. Wie erläutert, ist die Konsole 36 entlang der Vertikalführung 38 durch Ansteuerung des Zentrierantriebs 34 in Vertikalrichtung verfahrbar. Der Zentrierantrieb 34 ist als elektromotorischer Antrieb ausgeführt, dessen Antriebsspindel an der Konsole 36 angreift, um diese zu verstellen. Auf der Konsole sind in Horizontalrichtung verfahrbar zwei Zentrierbacken 42, 44 geführt, die im dargestellten geschlossenen Zustand vier Zentrieröffnungen 46a, 46b, 46c, 46d begrenzen, die jeweils unterschiedlichen Kabelquerschnitten bzw. Aderendhülsendurchmessern zugeordnet sind.

Die in Figur 5 oben liegenden Zentrieröffnungen 46c, 46d sind dabei beispielsweise zum Vercrimpen von Kabeln mit einem Durchmesser von 2,5 mm bzw. 1,5 mm vorgesehen. Die darunter liegende Zentrieröffnung 46b ist für Kabelquerschnitte mit 1,0 mm und die unterste Zentrieröffnung 46a für Kabelquerschnitte mit 0,5 mm und 0,75 mm zugeordnet. D. h., für die vergleichsweise kleinen Querschnitte reicht eine einzige gemeinsame Zentrieröffnung 46a aus. Diese Durchmesserangaben sind lediglich beispielhafter Natur. Bei einer derartigen Aufteilung wären dann entsprechend auf den fünf Trommelmagazinen 2a bis 2e geeignete Aderendhülsen für diese Durchmesser (0,5 mm, 0,75 mm, 1,0 mm, 1,5 mm, 2,5 mm) vorgesehen. Das Öffnen und Schließen der beiden Zentrierbacken 42, 44 erfolgt über pneumatische oder elektromotorische Schließantriebe 48, 50, die an der Konsole 36 gelagert sind und mit ihren Betätigungselementen an jeweiligen Zentrierbacken 42, 44 angreifen.

Die Ansteuerung der Zentriereinrichtung 22 erfolgt so, dass je nach in die Crimpposition verbrachter Aderendhülse die entsprechend vorgesehene Zentrieröffnung mit Bezug zur Crimpposition ausgerichtet wird. Zum Vereinfachen des Zentriervorgangs sind diese Zentrieröffnungen 46 zum Crimpkopf 26 hin konifiziert, so dass das Einführen des Kabelendes erleichtert ist.

In der Darstellung gemäß Figur 5 sichtbar ist auch eine sich in einer Übergabeposition befindliche Aderendhülse 52, die gemäß den vorbestimmten Ausführungen für einen mittleren Kabel-Durchmesser von 1,0 mm vorgesehen ist. Diese Aderendhülse 52 wird über die vorbeschriebene mittlere Fördereinheit 8c in die dargestellte Übergabeposition gefördert und dann mittels einer Schneideinrichtung 54 vom Gurtband abgetrennt, das entlang der zugeordneten Führungsbahn, im vorliegenden Fall der Führungsbahn 6c geführt ist. Während dieses Abtrennens wird die Aderendhülse 52 von einem Greifer 56 des an der Führungssäule 30 verfahrbaren Shuttles 24 gehalten. Nach dem Abtrennen fährt das Shuttle 24 dann nach unten in die Crimpposition, so dass das Kabelende durch die entsprechend lagepositionierte Zentrieröffnung 46b zugeführt werden kann.

Gemäß Figur 5 ist auf der Grundplatte 19 unterhalb der Zentriereinrichtung 22 ein Fangtrichter 58 angeordnet, in den Reste des Gurtbandes oder fehlerhaft vercrimpte Aderendhülsen oder dergleichen hineinfallen. Diese Teile fallen in einen Sammelbehälter 60, der wie in Figur 4 sichtbar, zum Entleeren aus der Rückwand herausgezogen werden kann.

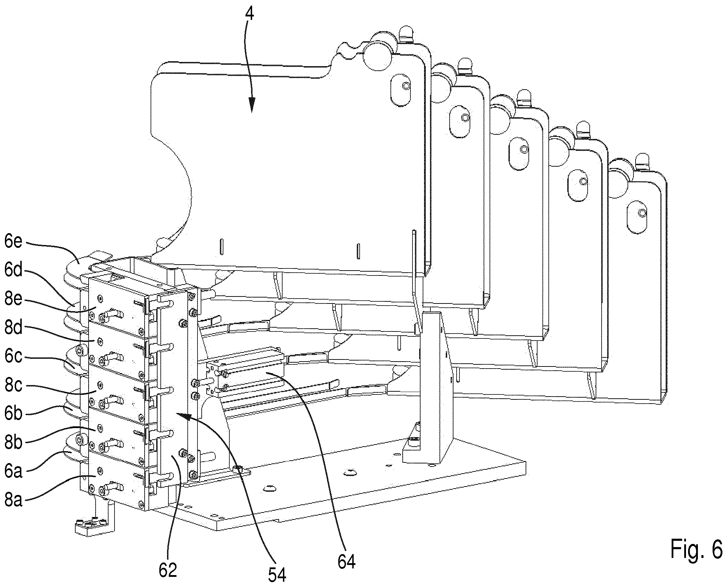

Die Funktion der Schneideinrichtung 44 wird anhand Figur 6 erläutert, die lediglich die Fördereinheiten 8a bis 8e, Teile der zugehörigen Führungsbahnen 6a bis 6e sowie die Schneideinrichtung 54 zeigt. Diese hat einen Schneidbalken 62, der mittels eines Pneumatikzylinders 64 in Horizontalrichtung verstellbar ist, um die sich in der Übergabeposition befindliche Aderendhülse 52 vom zugehörigen Gurtband abzutrennen. Dem entsprechend ist der Pneumatikzylinder 64 in Verstellrichtung, d. h., in Horizontalrichtung angeordnet.

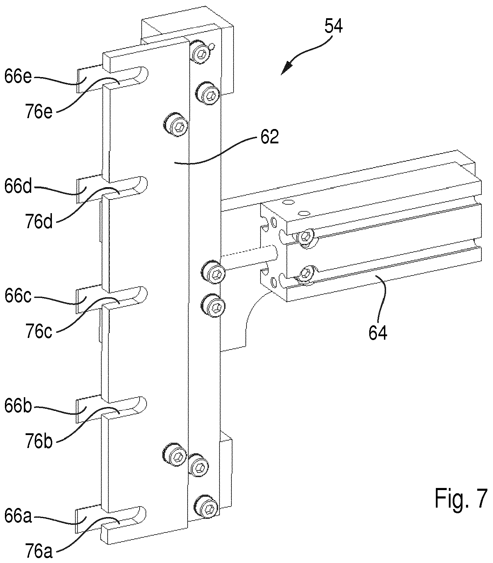

Figur 7 zeigt eine Einzeldarstellung der Schneideinrichtung 54 mit dem vom Pneumatikzylinder 64 betätigten Schneidbalken 62, an diesem sind insgesamt fünf Schneidmesser 66a, 66b, 66c, 66d, 66e befestigt, deren Axialabstand den Übergabepositionen der jeweiligen Fördereinheiten 8a bis 8e entspricht.

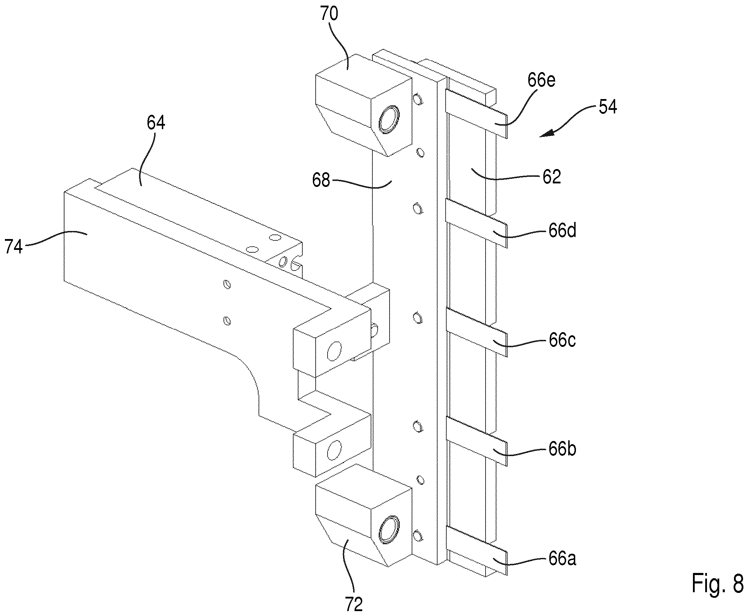

Figur 8 zeigt die Schneideinrichtung 54 von der Rückseite (bezogen auf die Ansicht in Figur 7) her. Demgemäß ist der Schneidbalken 62 mit den Messern 66a bis 66e an einer Messerplatte 68 gehalten, an der auch zwei Führungsblöcke 70, 72 befestigt sind, die von Führungselementen der Crimpmaschine durchsetzt sind, so dass die Schneidmesser 66a bis 66e in Horizontalrichtung exakt geführt sind. Der Pneumatikzylinder 64 ist an einer Stützkonsole 74 befestigt, die gehäusefest angeordnet ist. Gemäß der Darstellung in Figur 7 sind im Bereich der Messer 66a bis 66e am Schneidbalken 62 Langlöcher 76a, 76b, 76c, 76d und 76 e ausgeführt.

Wie aus der Darstellung gemäß Figur 5 entnehmbar, tauchen die Greifer beim Halten der Aderendhülse 52 in den Raum zwischen zwei benachbarten, über die Langlöcher 76 auskragenden Schneidmessern 66a bis 66e hinein.

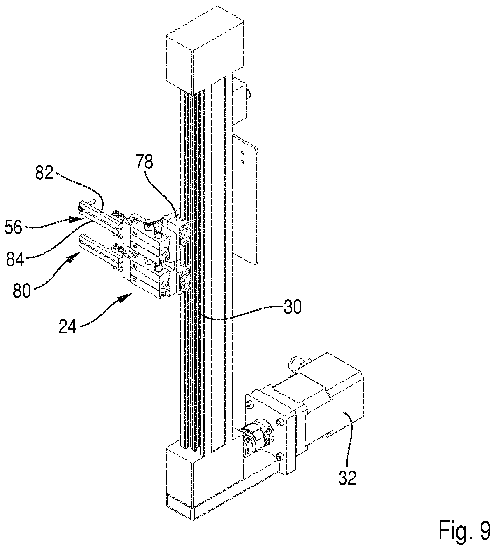

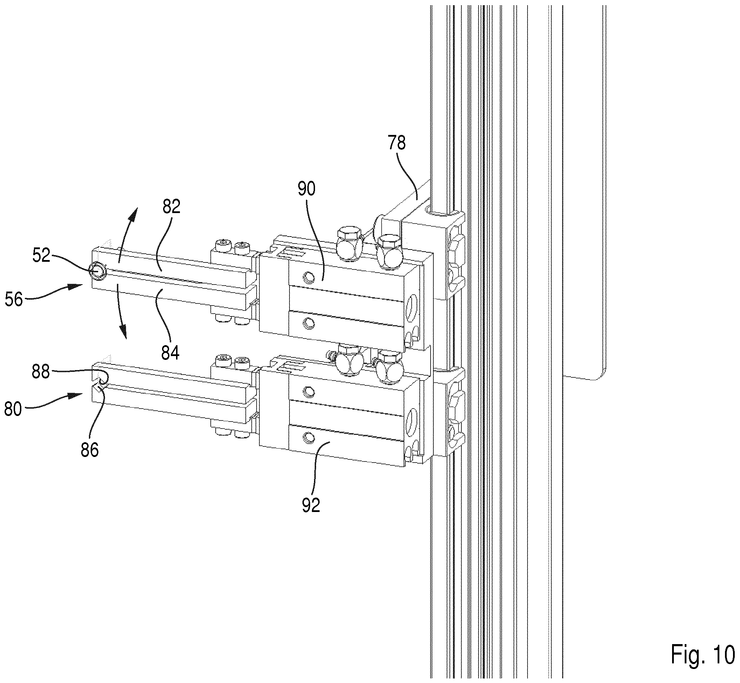

Einzelheiten des Shuttles werden anhand der Figuren 9 und 10 erläutert.

Figur 9 zeigt eine Einzeldarstellung des Shuttles 24 mit den zugehörigen Führungselementen. Wie erläutert, ist das Shuttle 24 mit einem Shuttleschlitten 78 in Vertikalrichtung verfahrbar entlang der Führungssäule 30 geführt. Der Antrieb erfolgt elektromotorisch über den Shuttleantrieb 32, dessen Antriebsachse um 90° gegenüber der Vertikalachse versetzt ist, so dass eine entsprechende Umlenkung im Antriebsstrang erforderlich ist, um mit dem Schlitten 78 zu verfahren. Der Schlitten 78 trägt beim dargestellten Ausführungsbeispiel zwei übereinanderliegende (Ansicht nach Figur 9) Greifer 56, 80, die jeweils zwei Greiferarme 82, 84 haben (siehe Figur 10). Diese Greiferarme 82, 84 haben an ihrem Endabschnitt jeweils zwei Greifausnehmungen 86, 88, die an die Kontur der zu verarbeitenden Kontaktelemente, im vorliegenden Fall der Aderendhülsen angepasst sind, so dass sämtliche Größen zuverlässig erfassbar sind. Zum Aufnehmen der Aderendhülse 52 können die Greiferarme 82, 84 in Pfeilrichtung, d. h., in Vertikalrichtung auseinander gefahren werden. Diese Auseinanderfahrbewegung erfolgt pneumatisch über jeweils einen Greiferzylinder 90, 92, der die Öffnungs- und Schließbewegung der Greiferarme 82, 84 steuert. Die Druckluftversorgung der Greiferzylinder 90, 92 erfolgt über die Gliederkette 40. Die entsprechenden Anschlusselemente sind in Figur 10 sichtbar.

Dabei können die Greiferarme 82, 84 scherenförmig oder parallel zueinander bewegt werden um die Aderendhülse 52 aufzunehmen.

Der in den Figuren 9 und 10 dargestellte zweite Greifer 80 kann beispielsweise dazu verwendet werden, um eine weitere Aderendhülse oder ein sonstiges Kontaktteil, das durchaus einen anderen Querschnitt als die Aderendhülse 52 haben kann zu übernehmen um nach dem Vercrimpen der Aderendhülse 52 mit einem Ende des Kabels die über den Greifer 80 entnommene Aderendhülse oder das sonstige Kontaktelement auf das andere Ende dieses Kabels aufzusetzen.

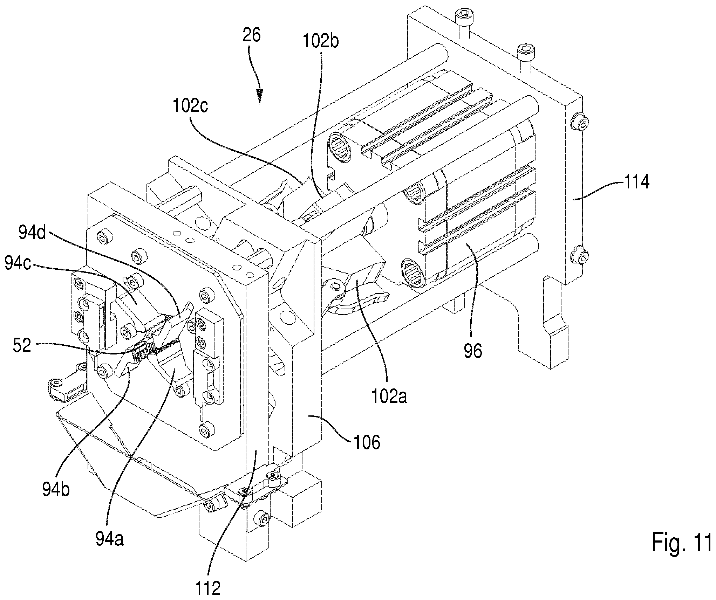

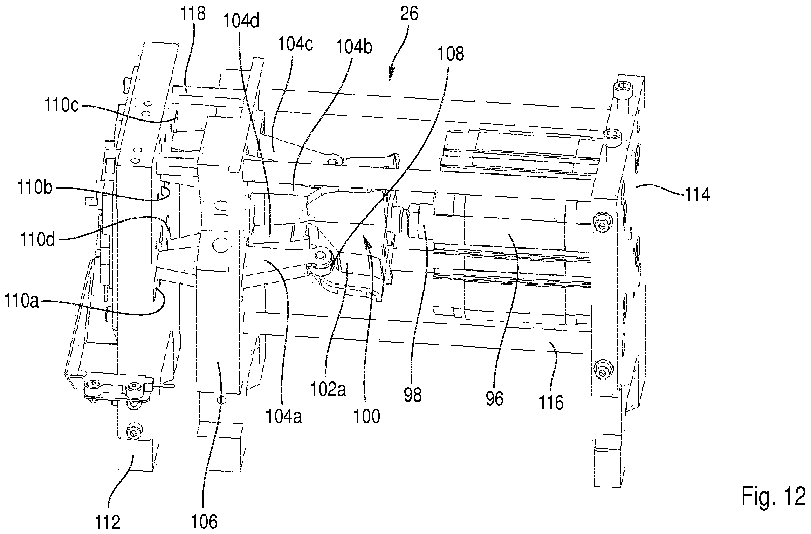

Das Crimpen erfolgt über den in den Figuren 11 und 12 in Einzeldarstellung gezeigten Crimpkopf 26. Dieser hat vier etwa um 90° zueinander versetzte Crimpbacken 94a, 94b, 94c und 94d, die in Figur 11 in ihrer Öffnungsposition gezeigt sind. Über das Shuttle 24 wird die zu vercrimpende Aderendhülse 52 in die dargestellte Crimpposition verfahren. Dabei hält der jeweilige Greifer 56 die Aderendhülse 52 an ihrem Kunststoffkragen, während die vier Crimpbacken 94a bis 94d an einem mit dem Kunststoffkragen verbundenen Röhrchen angreifen. Das abisolierte Kabelende wird über die Zentriereinrichtung 22 oder genauer gesagt über die in die richtige Relativposition verfahrene Zentrieröffnung in die Aderendhülse 52 eingeführt und anschließend der Crimpkopf 26 angesteuert, so dass sich die vier Crimpbacken 94a bis 94d in Radialrichtung nach innen bewegen und den Umformvorgang einleiten. Die Crimpkraft wird über einen Crimpzylinder 96 aufgebracht, der vorzugsweise elektromotorisch betätigt ist. An einem Crimpkolben 98 des Crimpzylinders 96 ist ein Kulissenkörper 100 geführt, an dem insgesamt vier Kulissen 102 in der gleichen Teilung wie die Crimpbacken 94 ausgebildet sind. In der Ansicht gemäß Figur 12 ist lediglich eine Kulisse 102a sichtbar. In der der Darstellung gemäß Figur 11 sind neben dieser Kulisse 102a zwei weitere Kulissen 102b, 102c zu sehen. Eine vierte Kulisse ist in den Darstellungen gemäß den Figuren 11 und 12 nach unten hin orientiert und nicht sichtbar.

Beim Ausfahren des Crimpkolbens 98 werden über die Kulissen 102 Crimphebel 104a, 104b, 104c, 104d verschwenkt, um die Crimpbacken 94a bis 94d zu verstellen. Diese Crimphebel 104 sind verschwenkbar in einer Platte 106 gehalten und liegen jeweils mit ihrem Endabschnitt über eine Rolle 108 an der zugeordneten Kulisse 102 an. Der andere Endabschnitt der Crimphebel 104 durchsetzt Schrägschlitze 110a, 110b, 110c bzw. 110d einer Frontplatte 112, wobei an den in der Ansicht nach Figur 11 aus der Frontplatte 112 vorstehenden Endabschnitten die Crimpbacken 94a bis 94d ausgebildet sind. Die Schrägschlitze 110a bis 110d ermöglichen die Radialverstellung der Crimpbacken 94a bis 94d.

Wie aus den Figuren 11 und 12 entnehmbar ist, vergrößert sich der Axialabstand der Kulissen 102 von der Achse des Crimpkolbens 98 zum Crimpzylinder 96 hin. Fährt nun der Crimpkolben 98 aus, so werden die Crimphebel 104 über die auf der jeweiligen Kulisse 102 abwälzenden Rollen 108 mit zunehmenden Hub verschwenkt, wobei der kulissenkörperseitige Endabschnitt der Crimphebel 104 in Radialrichtung nach außen verschwenkt wird und entsprechend der crimpbackenseitige Endabschnitt nach innen einschwenkt und somit die plastische Verformung der Aderendhülse bewirkt. Dieses nach innen schwenken ist durch die schräg angestellten Schrägschlitze 110 in der Frontplatte 112 ermöglicht. Nach dem Crimpvorgang fährt der Crimpkolben 98 wieder ein, so dass entsprechend die Crimpbacken 94 auseinanderfahren und die vercrimpte Einheit über ein geeignetes Handlingsgerät oder dergleichen entnommen werden kann und einem weiteren Verarbeitungsschritt zugeführt wird.

Der Hub des Crimpzylinders 96 kann optional vom Querschnitt der zu verarbeitenden Bauelemente abhängig sein.

Die gesamte Crimpeinheit ist über eine rückwärtige Stützplatte 114, die Platte 106 und die Crimplatte 112 an der Grundplatte 19 des Gehäuses abgestützt. Die beiden Platten 106, 114 sind über Zugstreben 116 miteinander verbunden. Zwischen der Platte 106 und der Crimpplatte 112 erstrecken sich mehrere Verbindungsbolzen 118.

Die erfindungsgemäße Crimpmaschine 1 ist so ausgeführt, dass über jedes Trommelmagazin 2 und jede zugeordnete Fördereinheit 8 bzw. Führungsbahn 6 jeder zu verarbeitende Querschnitt zugeführt werden kann.

Durch entsprechende Programmierung der Steuereinheit über das Bedienfeld 12 kann eine vorbestimmte Sequenz eingestellt werden, über die unterschiedliche Aderendhülsen/Kontaktelemente mit unterschiedlichen Kabeln konfektioniert werden können. Dies setzt allerdings voraus, dass die zu bearbeitenden Kabel in der vorgegebenen Reihenfolge automatisch oder von Hand zugeführt werden.

Je nach über das Bedienfeld 12 vorgegebener Fertigungsaufgabe wird die Zentriereinrichtung 22 über den Zentrierantrieb 34 mit der zugehörigen Zuführöffnung 20 mit Bezug zur Crimpposition, d. h., zur Achse des Crimpkopfs 16 ausgerichtet. Gleichzeitig wird über die Fördereinheit 8, die dem zu vercrimpenden Kontaktelement zugeordnet ist, das betreffende Gurtband um einen Schritt in Richtung zur Übergabeposition verfahren, so dass die am Ende angeordnete Aderendhülse 52 in dieser Übergabeposition angeordnet ist. Über den Shuttleantrieb 32 wird dann der Greifer 56 zur Übergabeposition gefahren und durch Ansteuerung der Greiferzylinder 90, 92 die Aderendhülse entlang der Greiferausnehmungen 86, 88 gehalten. Nach dieser Festlegung der Aderendhülse 52 führt die Schneideinrichtung 54 mit der Messerplatte 68 einen Horizontalhub hin zum Gurtband aus, wobei lediglich das der betreffenden Aderendhülse zugeordnete Schneidmesser 66 in Wirkeingriff gelangt. Nach dem Abtrennen der Aderendhülse vom Gurtband wird diese über das Shuttle in die Crimpposition zwischen die Crimpbacken 94 gefahren und dann über die Zuführöffnung 20 das abisolierte Kabelende eingeführt. Das Einführen kann über einen Sensor erfasst werden, so dass nach dem Einführen der Crimpkopf 26 in der vorbeschriebenen Weise betätigt wird, um die Aderendhülse mit dem Kabelende zu vercrimpen.

Offenbart ist eine Crimpmaschine mit einer Vielzahl von Magazinen für Kontaktelemente, die über eine Fördereinrichtung zu einer Übergabeposition transportierbar sind. Mittels einer Transporteinrichtung wird ein zu vercrimpendes Bauteil dann von der Übergabeposition in eine Crimpposition gebracht. Diese Transporteinrichtung ist allen Speicheranordnungen zugeordnet.

### Bezugszeichenliste:

- 1: Crimpmaschine
- 2: Trommelmagazin
- 4: Magazinhalter
- 6: Führungsbahn
- 8: Fördereinheit
- 10: Gehäuse
- 12: Bedienfeld
- 14: Schloss
- 16: Abdeckung
- 18: Anschluss
- 19: Grundplatte
- 20: Zuführöffnung
- 22: Zentriereinrichtung
- 24: Shuttle
- 26: Crimpkopf
- 28: Anschlussklemmen
- 30: Führungssäule
- 32: Shuttleantrieb
- 34: Zentrierantrieb
- 36: Konsole
- 38: Vertikalführung
- 40: Gliederkette
- 42: Zentrierbacken
- 44: Zentrierbacken
- 46: Zentrieröffnung
- 48: Schließantrieb
- 50: Schließantrieb
- 52: Aderendhülse
- 54: Schneideinrichtung
- 56: Greifer
- 58: Fangtrichter
- 60: Sammelbehälter
- 62: Schneidbalken
- 64: Pneumatikzylinder
- 66: Schneidmesser
- 68: Messerplatte
- 70: Führungsblock
- 72: Führungsblock
- 74: Stützkonsole
- 76: Langloch
- 78: Schlitten
- 80: Greifer
- 82: Greiferarm
- 84: Greiferarm
- 86: Greifausnehmung
- 88: Greifausnehmung
- 90: Greiferzylinder
- 92: Greiferzylinder
- 94: Crimpbacken
- 96: Crimpzylinder
- 98: Crimpkolben
- 100: Kulissenkörper
- 102: Kulisse
- 104: Crimphebel
- 106: Platte
- 108: Rolle
- 110: Schrägschlitz
- 112: Frontplatte
- 114: Stützplatte
- 116: Zugstrebe
- 118: Verbindungsbolzen

## Patentansprüche

1. Crimpmaschine zum Verpressen von Kontaktelementen mit einem Endabschnitt eines Leiters, beispielsweise eines Kabelendes, mit einer Speicheranordnung für die Kontaktelemente, einer Transporteinrichtung zum Zuführen der Kontaktelemente zu einem Crimpkopf (16) und einer Zentriereinrichtung (22) für den Leiter, wobei zumindest zwei Speicher, vorzugsweise fünf Speicher vorgesehen sind, denen eine gemeinsame Transporteinheit zum Transport eines Kontaktelementes von einer Übergabeposition zu einer Crimpposition zugeordnet ist, wobei die Transporteinrichtung ein Shuttle (24) zur Übernahme des sich in der Übergabeposition befindlichen Kontaktelements und zu dessen Transport zum Crimpkopf (26) hat, **dadurch gekennzeichnet, dass** das Shuttle (24) zwei parallel angeordnete Greifer (56, 80) hat, wobei einer das sich in der Übergabeposition befindliche Kontaktelement greift und der zweite ein in einem folgenden Arbeitsgang zu vercrimpendes Kontaktelement greift.

2. Crimpmaschine nach Patentanspruch 1, wobei jedem Speicher eine Fördereinheit (8) zum Fördern eines zu verpressenden Kontaktelements in die Übergabeposition zugeordnet ist.

3. Crimpmaschine nach Patentanspruch 1, wobei das Shuttle (24) zumindest einen Greifer (56, 80) hat, der am Kontaktelement, vorzugsweise quer zur Kontaktelementlängsachse, angreift.

4. Crimpmaschine nach Patentanspruch 3, wobei das Shuttle (24) entlang einer Führung geführt ist, so dass dieses in einer Ebene von der Übergabeposition in die Crimpposition verfahrbar ist.

5. Crimpmaschine nach einem der vorhergehenden Patentansprüche, wobei die Kontaktelemente jeweils als Gurtband auf einem Trommelmagazin (2) angeordnet sind.

6. Crimpmaschine nach Patentanspruch 5, mit einer Schneideinrichtung (54) zum Abtrennen des sich in der Übergabeposition befindlichen Kontaktelements vom Gurtband.

7. Crimpmaschine nach Patentanspruch 6, wobei die Schneideinrichtung (54) eine der Anzahl von Speichern entsprechende Anzahl von Schneidmessern (66) hat.

8. Crimpmaschine nach einem der vorhergehenden Patentansprüche, wobei die Zentriereinrichtung (22) eine Vielzahl von Zentrieröffnungen (46) hat, die entlang einer Führung mit Bezug zur Crimpposition ausrichtbar sind.

9. Crimpmaschine nach Patentanspruch 8, wobei die Zentriereinrichtung (22) zwei Zentrierbacken (42, 44) hat, die zum Entnehmen des verpressten Bauteils auffahrbar sind.

10. Crimpmaschine nach einem der vorhergehenden Patentansprüche, wobei die Übergabepositionen der Fördereinheiten (8) übereinanderliegend angeordnet sind und der oder die Greifer (56, 80) zwischen den von den Fördereinheiten (8) vorgegebenen Transportebenen verfahrbar sind und die Schneideinrichtung (54) quer dazu, d. h., parallel zur Achse des Crimpkopfs (24) und/oder der Zentriereinrichtung (22) verfahrbar ist.

11. Crimpmaschine nach einem der vorhergehenden Patentansprüche, mit einer Abdeckung (16) zur Abdeckung des Crimpbereichs und einer Sicherheitsschaltung, die bei ungewollter Öffnung der Abdeckung (16) die Energieversorgung und Betriebsmittelversorgung unterbricht und mit einer Rüstschaltung, die es ermöglicht, die Funktion der Crimpmaschine bei geöffneter Abdeckung (16) zu prüfen.

12. Crimpmaschine nach einem der vorhergehenden Patentansprüche, mit einer Zuführeinheit zum Zuführen des Leiters, vorzugsweise des Kabelendes in die Crimpposition.

13. Crimpmaschine nach einem der vorhergehenden Patentansprüche, mit einer Steuereinheit zum Steuern der Transporteinheit derart, dass ein sich in einer Übergabeposition befindliches Kontaktelement übernommen und zur Crimpposition verfahrbar ist.

## Claims

1. A crimping machine for crimping contact elements with an end portion of a conductor, for instance, a cable end, comprising a storage arrangement for the contact elements, a transport device for feeding the contact elements to a crimping head (16), and a centering device (22) for the conductor, wherein at least two storages, preferably five storages, are provided to which a common transport unit is assigned for transporting a contact element from a transfer position to a crimping position, wherein the transport device has a shuttle (24) for taking over the contact element being in the transfer position and for transporting it to the crimping head (26), **characterized in that** the shuttle (24) has two grippers (56, 80) arranged in parallel, wherein one is gripping the contact element being in the transfer position and the second one is gripping a contact element to be crimped in a subsequent operation.

2. The crimping machine according to claim 1, wherein each storage is assigned to a conveyor unit (8) for conveying a contact element to be crimped to the transfer position.

3. The crimping machine according to claim 1, wherein the shuttle (24) has at least one gripper (56, 80) engaging on the contact element, preferably transversely to the longitudinal axis of the contact element.

4. The crimping machine according to claim 3, wherein the shuttle (24) is guided along a guide such that it is movable in one plane from the transfer position to the crimping position.

5. The crimping machine according to one of the preceding claims, wherein the contact elements are each arranged as a belt strap on a drum magazine.

6. The crimping machine according to claim 5, comprising a cutting device (54) for separating the contact element being in the transfer position from the belt strap.

7. The crimping machine according to claim 6, wherein the cutting device (54) has a number of cutting knives (66) corresponding to the number of storages.

8. The crimping machine according to one of the preceding claims, wherein the centering device (22) has a plurality of centering apertures (46) adapted to be orientated along a guide with respect to the crimping position.

9. The crimping machine according to claim 8, wherein the centering device (22) has two centering jaws (42, 44) which are adapted to be moved apart for removing the crimped component.

10. The crimping machine according to one of the preceding claims, wherein the transfer positions of the conveyor units (8) are positioned on top of each other and the gripper(s) (56, 80) is/are movable between the transport planes predetermined by the conveyor units (8), and the cutting device (54) is movable transversely thereto, i.e. in parallel to the axis of the crimping head (24) and/or the centering device (22).

11. The crimping machine according to one of the preceding claims, comprising a cover (16) for covering the crimping area and a safety circuit interrupting the energy supply and the equipment supply in the case of undesired opening of the cover (16), and a set-up circuit enabling to check the function of the crimping machine when the cover (16) is open.

12. The crimping machine according to one of the preceding claims, comprising a feeding unit for feeding the conductor, preferably the cable end, to the crimping position.

13. The crimping machine according to one of the preceding claims, comprising a control unit for controlling the transport unit such that a contact element being in a transfer position is taken over and is movable to the crimping position.

## Revendications

1. Machine de sertissage pour la compression d'éléments de contact avec une extrémité de section d'un conducteur, par exemple d'une extrémité de câble, avec un réseau de mémoire pour les éléments de contact, un appareil de transport pour l'alimentation en éléments de contact vers une tête de sertissage (16) et un appareil de centrage (22) pour le conducteur, dans laquelle au moins deux mémoires, de préférence cinq mémoires sont prévues, auxquelles est attribuée une unité de transport commune pour le transport d'un élément de contact d'une position de transfert vers une position de sertissage, dans laquelle l'appareil de transport présente une navette (24) pour la reprise de l'élément de contact se trouvant dans la position de transfert et pour son transport vers la tête de sertissage (26), **caractérisée en ce que** la navette (24) présente deux pinces (56, 80) disposées en parallèle, dans laquelle l'une saisit un élément de contact se trouvant dans la position de transfert et la seconde saisit un élément de contact à sertir dans une opération de travail suivante.

2. Machine de sertissage selon la revendication 1, dans laquelle une unité d'alimentation (8) pour l'alimentation d'un élément de contact à sertir est attribuée à chaque mémoire dans la position de transfert.

3. Machine de sertissage selon la revendication 1, dans laquelle la navette (24) présente au moins une pince (56, 80) qui s'engage sur l'élément de contact, de préférence de manière transversale à l'axe longitudinal de l'élément de contact.

4. Machine de sertissage selon la revendication 3, dans laquelle la navette (24) est conduite le long d'une direction de sorte que celle-ci peut être déplacée dans un plan d'une position de transfert dans une position de sertissage.

5. Machine de sertissage selon l'une quelconque des revendications précédentes, dans laquelle les éléments de contact sont agencés respectivement en tant que sangle sur un magasin en forme de tambour (2).

6. Machine de sertissage selon la revendication 5 avec un appareil de coupe (54) pour la séparation de l'élément de contact se trouvant dans la position de transfert et de la sangle.

7. Machine de sertissage selon la revendication 6, dans laquelle l'appareil de coupe (54) présente un nombre de lames de coupe (66) correspondant au nombre de mémoires.

8. Machine de sertissage selon l'une quelconque des revendications précédentes, dans laquelle l'appareil de centrage (22) présente une pluralité d'ouvertures de centrage (46) qui peuvent être alignées le long d'une direction en rapport avec la position de sertissage.

9. Machine de sertissage selon la revendication 8, dans laquelle la direction de centrage (22) présente deux mâchoires de centrage (42, 44) qui peuvent être imbriquées pour retirer les composants comprimés.

10. Machine de sertissage selon l'une quelconque des revendications précédentes, dans laquelle les positions de transfert des unités d'alimentation (8) sont disposées superposées et la ou les pinces (56, 80) peuvent être déplacées entre les plans de transport prédéterminés par les unités d'alimentation (8) et l'appareil de coupe (54) est transversal par rapport à celles-ci, c'est-à-dire qu'il peut être déplacé parallèlement à l'axe de la tête de sertissage (24) et/ou de l'appareil de centrage (22).

11. Machine de sertissage selon l'une quelconque des revendications précédentes, avec un couvercle (16) pour couvrir la zone de sertissage et un circuit de sécurité qui interrompt l'approvisionnement en énergie et l'approvisionnement des moyens de production en cas d'ouverture involontaire du couvercle (16) et avec un circuit d'équipement qui permet de vérifier le fonctionnement de la machine de sertissage lorsque le couvercle (16) est ouvert.

12. Machine de sertissage selon l'une quelconque des revendications précédentes, avec une unité d'alimentation pour l'alimentation du conducteur, de préférence de l'extrémité de câble dans la position de sertissage.

13. Machine de sertissage selon l'une quelconque des revendications précédentes, avec une unité de commande pour la commande de l'unité de transport de telle sorte qu'un élément de contact se trouvant dans une position de transfert est pris en charge et peut être déplacé jusqu'à la position de sertissage.
